# EUROPÄISCHE PATENTSCHRIFT

(11) **EP 0 389 960 B1**
(45) Veröffentlichungstag und Bekanntmachung des Hinweises auf die Patenterteilung: **17.01.1996**
(21) Anmeldenummer: 90105403.1
(22) Anmeldetag: 22.03.1990
(51) Int. Cl.: C04B 35/00, H01L 39/12

(54) **Dichte, supraleitende Körper mit Textur**
Dense, superconducting textured bodies
Corps superconducteur dense à texture

(30) Priorität: 25.03.1989 DE 3909882
(43) Veröffentlichungstag der Anmeldung: 03.10.1990
(73) Patentinhaber: HOECHST AKTIENGESELLSCHAFT, D-65926 Frankfurt am Main (DE)
(72) Erfinder: Schwarz, Martin, Dr., W-6230 Frankfurt am Main 80 (DE); Küllmer, Iris, D-6230 Frankfurt am Main 80 (DE); Bock, Joachim, Dr., D-5042 Erfstadt-Lechenich (DE)

(56) Entgegenhaltungen:
- EP-A- 0 285 107
- EP-A- 0 298 647
- EP-A- 0 298 648
- EP-A- 0 351 037

## Beschreibung

Die vorliegende Erfindung betrifft dichte, oxidkeramische supraleitende Körper mit einem Gehalt an Kupfer und einer vorteilhaften, regelmäßigen Anordnung der Kristallite sowie ein Verfahren zu ihrer Herstellung.

Die jüngst aufgefundenen Hochtemperatur-supraleitenden Verbindungen auf der Basis von Y-Ba-Cu-O, Bi-Sr-Ca-Cu-O oder Tl-Ba-Ca-Cu-O versprechen hinsichtlich ihrer hohen kritischen Temperaturen T_{c} eine Vielzahl attraktiver Anwendungsmöglichkeiten. Nachteilig ist dabei, daß die für Anwendungen eines Massivkörpers (d. h. nicht in Form dünner Schichten) die für viele Anwendungszwecke entscheidende Stromtragefähigkeit nur niedrige Werte aufweist. Als Gründe hierfür werden neben Verunreinigungen an den Korngrenzen ("weak links") vor allem die Tatsache angesehen, daß diese Supraleiter eine schichtartige Kristallstruktur aufweisen, die zu einer Anisotropie wichtiger physikalischer Eigenschaften führt. Beispielsweise hat man an Einkristallen von YBa₂Cu₃O₇₋ₓ nachgewiesen, daß supraleitende Ströme nur in einer Ebene fließen, die senkrecht zur Gitterachse c verläuft. Ein ungestörter Stromfluß kann deshalb nur dann beobachtet werden, wenn die einzelnen Kristalle parallel zueinander ausgerichtet und eng benachbart sind. Günstig für eine parallele Ausrichtung ist es, wenn die einzelnen (nicht miteinander verbundenen) Kristallite eine Vorzugsrichtung aufweisen, beispielsweise langgestreckt sind.

Es bestand daher die Aufgabe, massive Supraleiter zu schaffen, bei denen die kristallinen Bereiche im wesentlichen parallel zueinander angeordnet sind.

Die Erfindung löst diese Aufgabe. Sie beruht auf der Erkenntnis, daß beim Sintern von Pulvern oxidkeramischer, Kupfer im Kristallgitter enthaltender Supraleiter-Pulver die Additive CuF₂ und KF die Ausbildung texturierter Proben begünstigen.

Gegenstand der Erfindung sind massive, oxidkeramische Supraleiter, die Kupfer im Kristallgitter enthalten und die ca. 0,04 bis 0,5 Mol Kupfer-(II)-fluorid oder Kaliumfluorid pro 100 g Kupfer des Supraleiters enthalten. Die Additive scheinen für die günstigen Eigenschaften des Supraleiters nicht entscheidend zu sein, da diese bei Herauslösen des Additivs nicht verschlechtert werden; ihre Gegenwart ist jedoch erforderlich, um zu erreichen, daß die einzelnen kristallinen Bereiche im wesentlichen parallel zueinander angeordnet verwachsen.

Beispiele für kupferhaltige, oxidkeramische Supraleiter gemäß der Erfindung sind Verbindungen der allgemeinen Formel MBa₂Cu₃Oₓ, wobei M für Yttrium oder ein Element der Nummern 61 bis 71 steht und x eine Zahl zwischen 6,5 und 7,2 ist, oxidkeramische Supraleiter des Systems Bi-Sr-Ca-Cu-O oder des Systems Bi-Pb-Sr-Ca-Cu-O.

Einsetzbar sind beispielsweise Supraleiter der Formeln (Bi,Pb)₂(Sr,Ca)₂CuOₐ (vgl. M. Takano et al, Jap. J. Appl. Phys. 27, 6 (1988), L 1041), Bi₂(Sr,Ca)₂CuO_{b}, Bi₂(Sr,Ca)₃Cu₂O_{c} und Bi₂(Sr,Ca)₄Cu₃O_{d}.

Bevorzugt sind Verbindungen des Systems MBa₂Cu₃Oₓ, insbesondere für den Fall, daß M = Y ist. Wenn man dagegen ein feines Pulver aus YBa₂Cu₃Oₓ in Abwesenheit von Additiven zu dichten Körpern sintert, so ist deren Gefüge hinsichtlich der Größe und Form der Körner völlig regellos aufgebaut. Insbesondere bestehen die Körner aus kleinen, unregelmäßig geformten kristallinen Bereichen mit Anteilen amorpher Bereiche.

Der Anteil der Additive Kupferfluorid und Kaliumfluorid liegt insbesondere bei 0,042 - 0,44 Mol pro 100 g Kupfer des Supraleiters. Bei diesen Zusätzen weisen die Kristalle der Supraleiter im allgemeinen ein Verhältnis von Länge/Durchmesser von 3:1 - 30:1 auf. Die Dichte erfindungsgemäßer Supraleiter der Formel MBa₂Cu₃Oₓ liegt im allgemeinen bei 6,0 bis 6,33 g/cm³.

Die erfindungsgemäßen Supraleiter lassen sich dadurch herstellen, daß man einen pulverförmigen, Kupfer im Gitter enthaltenden Supraleiter mit 0,04 bis 0,5 Mol, vorzugsweise 0,042 bis 0,44 Mol, insbesondere 0,045 bis 0,3 Mol Kupferfluorid oder Kaliumfluorid pro 100 g Kupfer des Supraleiters mischt, die Mischung unter einen Druck von mindestens 1 MPa zu einem Formkörper verformt und diesen mindestens eine Stunde bei Temperaturen von 980 bis 1200°C insbesondere 1000 - 1050°C erhitzt. Ein alternativer Herstellungsprozeß geht von einem zur Bildung eines Supraleiters führenden Gemisch der Ausgangskomponenten, wie z. B. der betreffenden Metalloxide, -carbonate oder -nitrate aus, dem CuF₂ oder KF zugesetzt wird und das in analoger Weise zur Reaktion gebracht wird. Dabei tritt fast immer mindestens teilweise eine schmelzflüssige Phase auf. Wahrscheinlich ist diese schmelzflüssige Phase verantwortlich für die Ausbildung zusammenhängender kristalliner Bereiche. Dieses Erhitzen dauert mindestens zwei Stunden, vorzugsweise mindestens 5 Stunden. In allen Fällen ist es vorteilhaft, wenn man das Erhitzen in einer Atmosphäre vornimmt, die freien Sauerstoff enthält. Es ist ferner vorteilhaft, wenn man nach diesem Schritt auf eine Temperatur von mindestens 400°C abkühlt, bei der keine flüssige Phase mehr vorhanden ist, beispielsweise auf Temperaturen von 880 bis 900°C, und man den Ansatz bei dieser Temperatur in Gegenwart einer Sauerstoff enthaltenden Atmosphäre mindestens eine Stunde, vorzugsweise aber mindestens 5 Stunden hält. Besonders bevorzugt ist es, wenn die Dauer des Erhitzens in beiden Stufen im Bereich von 10 bis 20 Stunden, vorzugsweise bei 15 Stunden liegt. In einigen Fällen kann man das Additiv bereits bei der Herstellung des Ausgangsprodukts (oxidkeramischer Supraleiter mit Kupfer im Kristallgitter) einsetzen.

Die Stromtragfähigkeit der Produkte, die nach diesem Verfahren erhalten werden, ist deutlich höher als bei Produkten, die ohne Additive gepreßt und gesintert wurden.

Die Erfindung wird durch die Beispiele näher erläutert.

### Beispiel 1

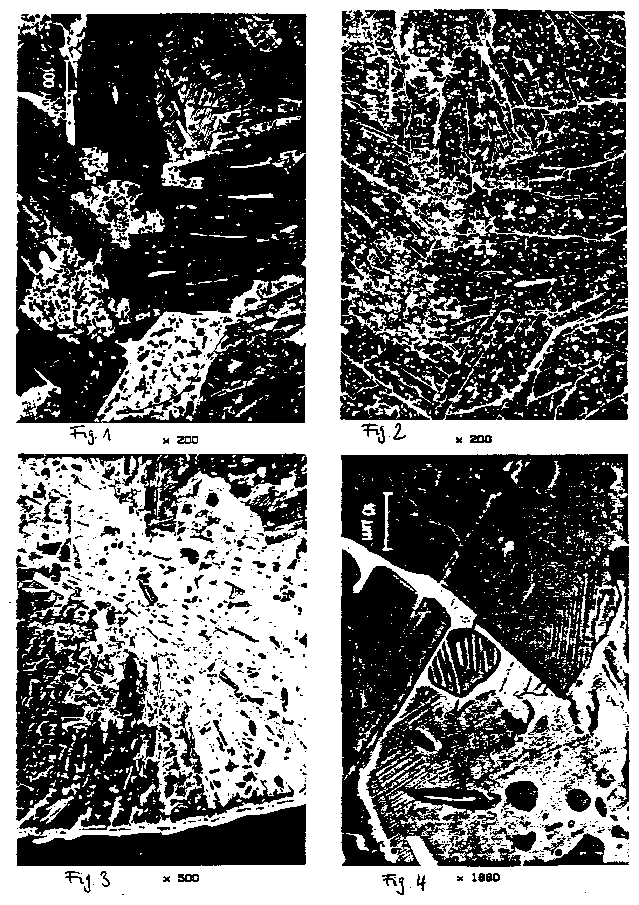

YBa₂Cu₃Oₓ-Pulver wird mit 5 Gew.-% fein gepulvertem CuF₂ gemischt und unter einem Druck von ca. 300 MPa (3 kbar) zu Formkörpern gepreßt. Die Formkörper werden wie folgt gesintert:
Aufheizen in 10 h auf 1000°C
20 h Tempern bei 1000°C
Abkühlen in 2 h auf 900°C
10 h Tempern bei 900°C
Abkühlen in 10 h auf 20°C
Schliffbilder der hergestellten Probe zeigen ein geordnetes, texturiertes Gefüge mit einkristallinen Domänen in der Größenordnung von ca. 100-1000 µm, die lamellar angeordnet sind. Man erkennt in Fig. 1 bis 4 große, geordnet aufgebautet kristalline Bereiche und Zwillingsdomänen, die auch über Korngrenzen hinweg parallel verlaufen.

### Beispiel 2

Wenn man Beispiel 1 mit einem Pulver gleicher Zusammensetzung aber mit anderem Sauerstoffgehalt oder anderer Korngrößen-Verteilung wiederholt, so werden dichte supraleitende Körper mit Textur und vergleichbaren Eigenschaften erhalten.

## Patentansprüche

1. Verfahren zur Herstellung eines massiven oxidkeramischen Supraleiters, der aus den Elementen Wismut, Strontium, Calcium, Kupfer und Sauerstoff aufgebaut ist und im wesentlichen aus langgestreckten, parallel angeordneten, miteinander verwachsenen Kristallen besteht, dadurch gekennzeichnet, daß man einen pulverförmigen Supraleiter, der Kupfer im Gitter enthält, mit 0,04 bis 0,5, vorzugsweise 0,042 bis 0,44 Mol CuF₂ oder Kaliumfluorid pro 100 g Kupfer des Supraleiters vermischt, die Mischung unter einem Druck von mindestens 1 MPa zu einem Formkörper verformt und diesen mindestens 5 Stunden bei 980 bis 1200°C, insbesondere 1000 bis 1050°C erhitzt.

2. Verfahren zur Herstellung eines massiven oxidkeramischen Supraleiters, der im wesentlichen aus langgestreckten, parallel angeordneten, miteinander verwachsenen Kristallen besteht, dadurch gekennzeichnet, daß man einen pulverförmigen Supraleiter, der eine Zusammensetzung der allgemeinen Formel MBa₂Cu₃Oₓ aufweist, wobei M für Yttrium oder ein Element der Nummern 61 bis 71 steht und x eine Zahl zwischen 6,5 und 7,2 ist, mit 0,04 bis 0,5, vorzugsweise 0,042 bis 0,44 Mol CuF₂ oder Kaliumfluorid pro 100 g Kupfer des Supraleiters vermischt, die Mischung unter einem Druck von mindestens 1 MPa zu einem Formkörper verformt und diesen mindestens 5 Stunden bei 980 bis 1200°C, insbesondere 1000 bis 1050°C erhitzt.

3. Verfahren nach Anspruch 1 oder 2, dadurch gekennzeichnet, daß man das Erhitzen in einer Atmosphäre vornimmt, die freien Sauerstoff enthält.

## Claims

1. A process for producing a solid oxide-ceramic superconductor which is made up of the elements bismuth, strontium, calcium, copper and oxygen and is essentially consisting of elongated crystals which are arranged in parallel and intergrown with one another, which comprises mixing a powdered superconductor which contains copper in the lattice with 0.04 to 0.5, preferably 0.042 to 0.44, mol of CuF₂ or potassium fluoride per 100 g of copper in the superconductor, deforming the mixture under a pressure of at least 1 MPa to produce a molded body and heating the latter for at least 5 hours at 980 to 1200°C, in particular 1000 to 1050°C.

2. A process for producing a solid oxide-ceramic superconductor which is essentially consisting of elongated crystals which are arranged in parallel and intergrown with one another, which comprises mixing a powdered superconductor which has a composition of the formula MBa₂Cu₃Oₓ, where M is yttrium or an element selected from those having the numbers 61 to 71 and x is a number between 6.5 and 7.2, with 0.04 to 0.5, preferably 0.042 to 0.44, mol of CuF₂ or potassium fluoride per 100 g of copper in the superconductor, deforming the mixture under a pressure of at least 1 MPa to produce a molded body and heating the latter for at least 5 hours at 980 to 1200°C, in particular 1000 to 1050°C.

3. The process as claimed in claim 1 or 2, wherein the heating is carried out in an atmosphere which contains free oxygen.

## Revendications

1. Procédé de préparation d'un supraconducteur massif en céramique à base d'oxyde, qui est constitué des éléments bismuth, strontium, calcium, cuivre et oxygène, et qui pour l'essentiel est constitué de cristaux allongés, en disposition parallèle, imbriqués les uns dans les autres, caractérisé en ce que l'on mélange à un supraconducteur pulvérulent, contenant du cuivre dans son réseau, de 0,04 à 0,5, de préférence de 0,042 à 0,44 mole de fluorure de cuivre ou de fluorure de potassium par 100 g de cuivre du supraconducteur, qu'on transforme le mélange en un produit façonné sous une pression d'au moins 1 MPa, et qu'on chauffe ce dernier pendant au moins 5 heures à des températures de 980 à 1200°C, en particulier de 1000 à 1050°C.

2. Procédé de préparation d'un supraconducteur massif en céramique à base d'oxyde, qui pour l'essentiel est constitué de cristaux allongés, en disposition parallèle, imbriqués les uns dans les autres, caractérisé en ce qu'on mélange à un supraconducteur pulvérulent, qui a une composition correspondant à la formule générale MBa₂Cu₃Oₓ, M étant l'yttrium ou un élément ayant les numéros atomiques de 61 à 71 et x est un nombre compris entre 6,5 et 7,2, une quantité de 0,04 à 0,5 et de préférence de 0,042 à 0,44 mole de CuF₂ ou de fluorure de potassium par 100 g de cuivre du supraconducteur, qu'on façonne le mélange sous une pression d'au moins 1 MPa pour obtenir un objet façonné, et qu'on chauffe ce dernier pendant au moins 5 heures à une température de 980 à 1200°C et en particulier de 1000 à 1050°C.

3. Procédé selon la revendication 1 ou 2, caractérisé en ce qu'on procède au chauffage dans une atmosphère contenant de l'oxygène libre.
